# EUROPEAN PATENT APPLICATION

(11) **EP 4 177 969 A1**
(43) Date of publication of application: **10.05.2023**
(21) Application number: 22204604.7
(22) Date of filing: 31.10.2022
(51) Int. Cl.: H01L 31/054, H01L 31/055, H01L 31/048

(54) **LIGHT CONCENTRATOR BASED ON QUANTUM DOT, AND PHOTOVOLTAIC MODULE INCLUDING THE SAME**

(30) Priority: 05.11.2021 KR 20210151081; 14.09.2022 KR 20220115440
(71) Applicant: Korea Electronics Technology Institute, Bundang-gu, Seongnam-si Gyeonggi-do 13509 (KR)
(72) Inventor: PARK, Kyoungwon, 05658 Seoul (KR); HAN, Chuljong, 16807 Yongin-si, Gyeonggi-do (KR); YI, Jeongmin, 16676 Suwon-si, Gyeonggi-do (KR)
(74) Representative: Isarpatent

(57) **Abstract**

A light concentrator based on a quantum dot may include a resin film layer in which quantum dots are dispersed, an upper layer in contact with an upper surface of the resin film layer, and a lower layer in contact with a lower surface of the resin film layer. Each of the upper layer and the lower layer may be selected from a glass layer or a polymer layer. A photovoltaic module may include the quantum dot-based light concentrator. By optimally adjusting the longest wavelength of the quantum dots, the average transmittance of the glass layer, the material of the polymer layer, and the cross-sectional aspect ratio (length/thickness) of the light concentrator, it is possible to maximize the efficiency of the quantum dot-based light concentrator and increase the efficiency of the photovoltaic module including the light concentrator.

## Description

### BACKGROUND

### Field

The disclosure relates to a light concentrator based on a quantum dot, and a photovoltaic module including the same. More specifically, the disclosure relates to a quantum dot-based light concentrator including a resin film layer with quantum dots dispersed and a glass layer or polymer layer in contact with upper and lower surfaces of the resin film layer, and capable of improving the power generation efficiency in a photovoltaic module by optimally adjusting the longest wavelength of the quantum dots, the average transmittance of the glass layer, the material of the polymer layer, and the cross-sectional aspect ratio (length/thickness) of the light concentrator.

### Description of Related Art

Quantum dot is a nano-sized semiconductor structure particle that emits light when stimulated with energy such as light.

The principle of the quantum dot is as follows. When the dimension of a substance is reduced due to the small size of the substance, the electron state density and energy change, so the properties of the substance also appear differently depending on the dimension. For example, small nanoparticles with a size of several nanometers exhibit a quantum confinement effect that does not appear in general materials.

Strictly speaking, reducing the dimension refers to confining electrons in a region smaller than the de Broglie wave length. A zero-dimensional quantum dot is not a point with no area at all, but actually a particle whose three-dimensional size is smaller than the de Broglie wave length. In quantum mechanics, the length of the wave, that is, the de Broglie wave, accompanied by all particles with momentum varies depending on the material, and in the case of semiconductors, it is about 10 nm. A semiconductor quantum dot consists of about one million electrons, but in reality, the number of unbound free electrons is about 1 to 100 because electrons are tightly bound to the atomic nucleus of the material. Therefore, the free electrons in the quantum dot can be represented as waves, and the energy and the density of states are quantized.

Semiconductor nanoparticles of 10 nm or less, which are smaller than the De Broglie wave length, have a relatively increased band gap energy as the particle size decreases. Therefore, even with the same material, dozens of colors can be realized by slightly adjusting the particle size. For this reason, it has been reported that quantum dots have considerable application potential in various fields such as displays [Seth Coe-Sullivan, Wing-Keung Woo, Jonathan S. Steckel, Moungi Bawendi, Vladimir Bulovic, "Tuning the performance of hybrid organic/inorganic quantum dot light-emitting devices", Organic Electronics, vol. 4, 123-130 (2003)], recording devices, sensors, nano-computers, biology, and medicine [X. Michalet, F. F. Pinaud, L. A. Bentolila, 1 J. M. Tsay, 1 S. Doose, 1. J. J. Li,1 G. Sundaresan, A. M. Wu, S. S. Gambhir, S. Weiss 1, "Quantum Dots for Live Cells, in Vivo Imaging, and Diagnostics", SCIENCE VOL 307, 538-544 (2005)].

Patent Document 1 (U.S. Patent Publication No. 2011/0171773 A1) relates to a method for making a planar concentrating solar cell assembly with silicon quantum dots, and discloses that a substrate disposed on both surfaces of a silicon quantum dot film is made of glass, plastic, or resin.

Patent Document 2 (Korean Patent Publication No. 2016-0061267) relates to an encapsulant employing non-cadmium quantum dots as a wavelength conversion material, and to a solar cell module and a light-emitting solar concentrator including the same, and discloses a polymer sheet containing the quantum dots.

Patent Document 3 (Korean Patent Publication No. 2021-0092521) relates to a sunlight concentrating device and a photovoltaic module including the same, and discloses a structure in which a low-refractive layer is disposed on both surfaces of a first quantum dot layer.

Meanwhile, the efficiency of a light concentrator based on quantum dots is affected by an appropriate dimension, medium (glass and polymer), and quantum dot photoluminescence characteristics. Specifically, the light concentrator should have an appropriate size (or dimension) to operate well in a realistic m² level, and when the transmittance of the medium is excellent, the light absorption by the quantum dots is facilitated and the high efficiency is guaranteed. Furthermore, the decrease in efficiency due to C-H stretching depending on the longest/shortest wavelength of the quantum dot [Bergren et. al., "High-performance CuInS₂, Quantum dot laminated glass luminescent solar concentrators for windows", ACS Nano, 3, 520 (2018)] is also a major consideration in the development of a high-efficiency light concentrator.

### [Prior Art Literature]

### [Patent Literature]

Patent Document 1: U.S. Patent Publication No. 2011/0171773 A1
Patent Document 2: Korean Patent Publication No. 2016-0061267
Patent Document 3: Korean Patent Publication No. 2021-0092521

### SUMMARY

The disclosure is intended to provide a light concentrator based on a quantum dot, and a photovoltaic module including the same, where the light concentrator based on a quantum dot comprises a resin film layer with quantum dots dispersed and a glass layer or polymer layer in contact with upper and lower surfaces of the resin film layer, and capable of improving the power generation efficiency in a photovoltaic module by optimally adjusting the longest wavelength of the quantum dots, the average transmittance of the glass layer, the material of the polymer layer, and the cross-sectional aspect ratio (length/thickness) of the light concentrator.

According to a first aspect of the disclosure, a light concentrator based on a quantum dot may include a resin film layer in which quantum dots are dispersed; an upper layer in contact with an upper surface of the resin film layer; and a lower layer in contact with a lower surface of the resin film layer, wherein each of the upper layer and the lower layer is selected from a glass layer or a polymer layer.

According to a second aspect of the disclosure, a light concentrator based on a quantum dot may include a polymer layer in which quantum dots are dispersed, wherein the polymer layer is provided in a form of slab.

In the light concentrator according to the first or second aspect, a longest wavelength of the quantum dot may be 650 nm to 900 nm.

In the light concentrator according to the first aspect, the glass layer may have an average transmittance of 91% to 95% at 400 nm to 1000 nm.

In the light concentrator according to the first or second aspect, the polymer layer may be selected from the group consisting of clear polyimide, fluorinated polymethyl methacrylate (fluorinated PMMA), and fluorinated polyimide.

In the light concentrator according to the first or second aspect, a cross-sectional aspect ratio (length/thickness) of the light concentrator may be 50 to 200.

According to the first aspect of the disclosure, a photovoltaic module may include a resin film layer in which quantum dots are dispersed; an upper layer in contact with an upper surface of the resin film layer; a lower layer in contact with a lower surface of the resin film layer; an adhesive provided on sides of the resin film layer, the upper layer, and the lower layer; and a photovoltaic cell attached to the adhesive, wherein each of the upper layer and the lower layer is selected from a glass layer or a polymer layer.

According to the second aspect of the disclosure, a photovoltaic module may include a polymer layer in which quantum dots are dispersed; an adhesive provided on sides of the polymer layer; and a photovoltaic cell attached to the adhesive, wherein the polymer layer is provided in a form of slab.

In the photovoltaic module according to the first or second aspect, a longest wavelength of the quantum dot may be 650 nm to 900 nm.

In the photovoltaic module according to the first aspect, the glass layer may have an average transmittance of 91% to 95% at 400 nm to 1000 nm.

In the photovoltaic module according to the first or second aspect, the polymer layer may be selected from the group consisting of clear polyimide, fluorinated polymethyl methacrylate (fluorinated PMMA), and fluorinated polyimide.

In the photovoltaic module according to the first or second aspect, a cross-sectional aspect ratio (length/thickness) of the light concentrator may be 50 to 200.

According to the disclosure, by optimally adjusting the longest wavelength of the quantum dots, the average transmittance of the glass layer, the material of the polymer layer, and the cross-sectional aspect ratio (length/thickness) of the light concentrator, it is possible to maximize the efficiency of the quantum dot-based light concentrator and increase the efficiency of the photovoltaic module including the light concentrator.

### BRIEF DESCRIPTION OF THE DRAWINGS

FIG. 1 shows the structure of a quantum dot light concentrator based on laminated glass or laminated polymer according to a first aspect of the disclosure.
FIG. 2 shows the structure of a quantum dot light concentrator having a quantum dot dispersion polymer layer in the form of a slab according to a second aspect of the disclosure.
FIG. 3 is a graph showing the transmittance measured depending on materials of resin/polymer layers constituting a light concentrator according to the disclosure.
FIG. 4 is a graph showing the transmittance measured for various polymers including polymethyl methacrylate (PMMA).
FIG. 5 is a graph showing the absorption coefficient [cm⁻¹] of resin/polymer made of polymethyl methacrylate (PMMA) and fluorinated PMMA.
FIG. 6 is a graph showing the photoluminescence spectrum of quantum dots constituting a light concentrator according to the disclosure.
FIG. 7 is a diagram showing the efficiency of a light concentrator measured through a Monte-Carlo simulator using length (mm) and thickness (mm) as variables for the square-sized light concentrator based on quantum dot 1 according to the disclosure.
FIG. 8 is a graph showing the transmittance depending on normal glass, low iron glass, and quartz glass.

### DETAILED DESCRIPTION

Hereinafter, embodiments of the disclosure will be described in detail with reference to the accompanying drawings. The following description is intended to enable those skilled in the art to which the disclosure pertains to easily practice the disclosure, and is not intended to limit the technical subject matter and scope of the disclosure.

In the disclosure, the term 'quantum dot' refers to a nano-sized semiconductor structure particle that emit light when stimulated with energy such as light.

In the disclosure, the term 'transmission' refers to a phenomenon that incident light is not absorbed by resin/polymer in which quantum dots are dispersed, and the term 'transmittance' refers to the ratio of light not absorbed by resin/polymer compared to incident light.

In the disclosure, the term 'longest wavelength' refers to a limit wavelength at which incident light is minimally absorbed by resin/polymer and maximally absorbed by quantum dots dispersed in the resin/polymer. For example, the 'longest wavelength of the quantum dot' may be the upper limit wavelength of the full width at half maximum (FWHM) in the photoluminescence spectrum of the quantum dot. The 'FWHM' (hereinafter also referred to as 'spectral FWHM') may be a difference between the upper limit wavelength and the lower limit wavelength at which energy in the photoluminescence spectrum of the quantum dot is 1/2 of the maximum relative radiant energy.

In the disclosure, the term 'slab' indicates that a quantum dot dispersion polymer constituting the light concentrator based on the quantum dot according to the second aspect is formed of 'one lump in a flat shape' rather than 'multiple layers'.

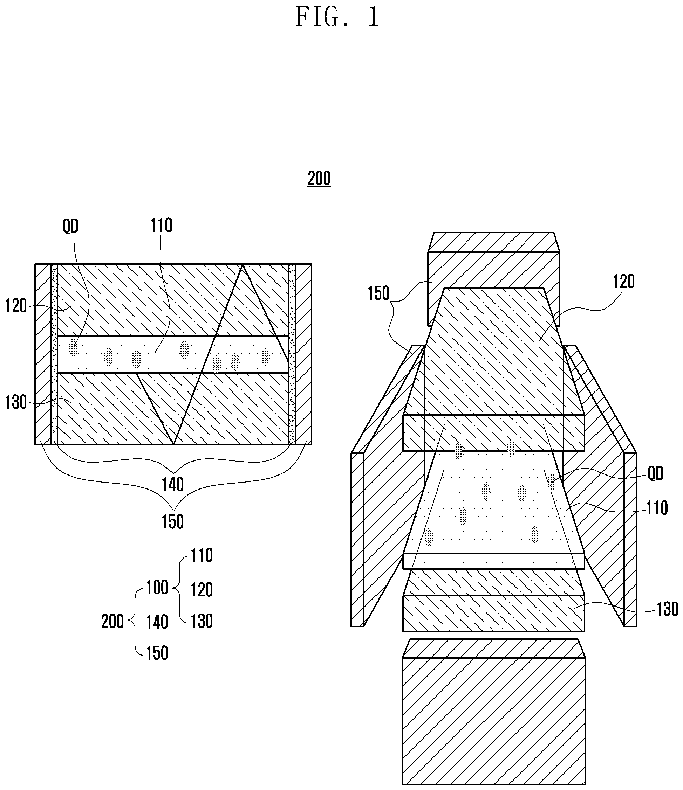

FIG. 1 shows the structure of a quantum dot light concentrator 100 based on laminated glass or laminated polymer and the structure of a photovoltaic module 200 including the light concentrator according to a first aspect of the disclosure.

Specifically, the quantum dot light concentrator 100 based on laminated glass or laminated polymer according to the first aspect of the disclosure includes a resin film layer 110 in which quantum dots (QD) are dispersed, an upper layer 120 in contact with an upper surface of the resin film layer 110, and a lower layer 130 in contact with a lower surface of the resin film layer 110. The upper layer 120 may be formed of a glass layer or a polymer layer, and the lower layer 130 may also be formed of a glass layer or a polymer layer.

In addition, the glass layer is preferably a low iron glass, a quartz glass, or a high transmittance glass equivalent thereto. The high transmittance glass preferably refers to a glass having an average transmittance of 94% at 400 to 700 nm, and more preferably a glass having an average transmittance of 94.5% at 400 to 700 nm. In addition, the polymer layer is also preferably formed of a material having high transmittance, such as clear polyimide, fluorinated polymethyl methacrylate, or fluorinated polyimide, and more preferably formed of fluorinated polymethyl methacrylate.

Meanwhile, the photovoltaic module 200 according to the first aspect of the disclosure includes the quantum dot light concentrator 100 composed of the resin film layer 110, the upper layer 120, and the lower layer 130, and further includes an adhesive 140 provided on sides of the quantum dot light concentrator 100, and a photovoltaic cell 150 attached to the adhesive 140.

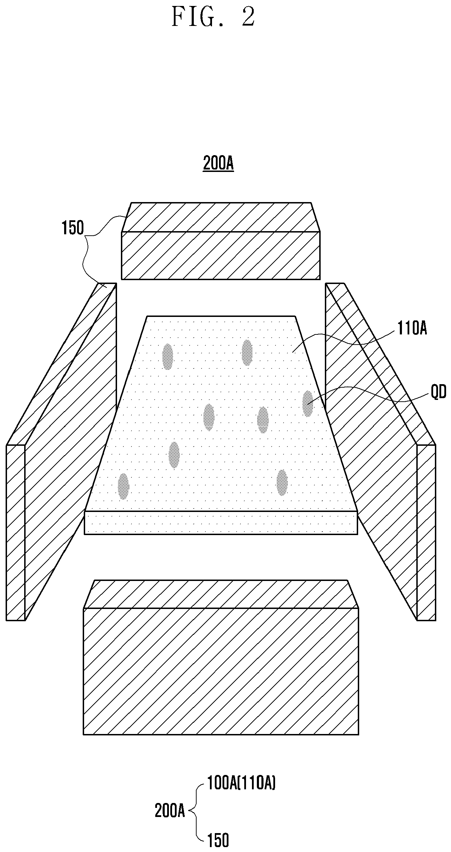

FIG. 2 shows the structure of a quantum dot light concentrator 100A having a quantum dot dispersion polymer layer in the form of a slab and the structure of a photovoltaic module 200A including the light concentrator according to a second aspect of the disclosure.

Specifically, the quantum dot light concentrator 100A according to the second aspect of the disclosure is composed of only a quantum dot dispersion polymer 110A in the form of a slab, unlike the quantum dot based light concentrator 100 according to the first aspect in which multiple layers are formed by laminated glass or laminated polymer positioned above and below the resin film layer 110A in which quantum dots (QD) are dispersed.

The quantum dot dispersion polymer 110A is preferably formed of a material having high transmittance, such as clear polyimide, fluorinated polymethyl methacrylate, or fluorinated polyimide, and more preferably formed of fluorinated polymethyl methacrylate.

Meanwhile, the photovoltaic module 200A according to the second aspect of the disclosure includes the quantum dot light concentrator 100A composed of the quantum dot dispersion polymer 110A in the form of a slab, and further includes the adhesive 140 (see FIG. 1) provided on sides of the quantum dot light concentrator 100A, and the photovoltaic cell 150 attached to the adhesive 140.

For reference, the adhesive 140 is made of a material having a refractive index similar to that of the glass layer or the polymer layer constituting the quantum dot light concentrator 100 or 100A in order to reduce Fresnel reflection. This allows the quantum dot light concentrator 100 or 100A according to the disclosure and the photovoltaic module 200 or 200A including the same to maintain high efficiency. Therefore, the adhesive 140 is preferably formed of a material having high transmittance, such as clear polyimide, fluorinated polymethyl methacrylate, or fluorinated polyimide, and more preferably formed of fluorinated polymethyl methacrylate.

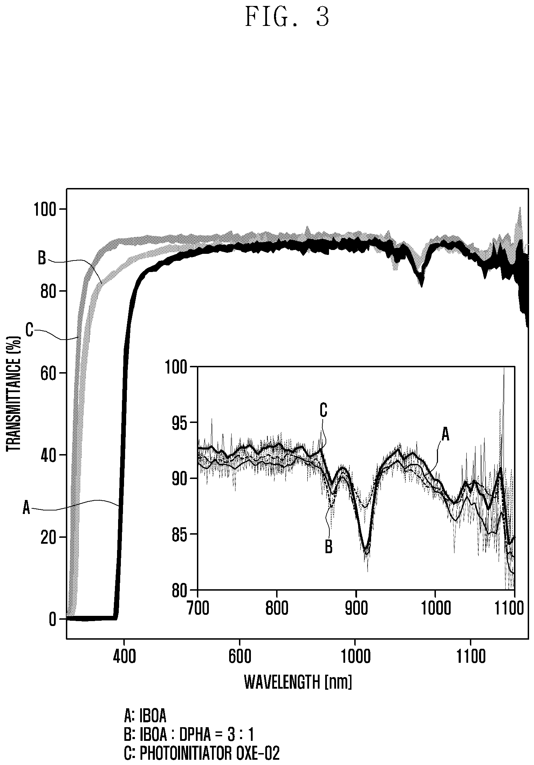

FIG. 3 is a graph of the transmittance measured using different materials for resin/polymer layers, that is, the resin film layer 110 and the polymer layers of the upper and lower layers 120 and 130 in the light concentrator 100 of FIG. 1 and the polymer layer 110A in the light concentrator 100A of FIG. 2.

Specifically, an experiment was conducted with resin/polymer including a material A of isobornylacrylate (IBOA), a material B in which the IBOA and dipentaerythritol hexaacrylate (DPHA) are mixed in a weight ratio of 3:1, and a material C in which photoinitiator Oxe-02 is added to the material B in a weight ratio of 3%. For each of the material A, the material B, and the material C, FIG. 3 shows the transmittance according to the wavelength of the corresponding resin/polymer.

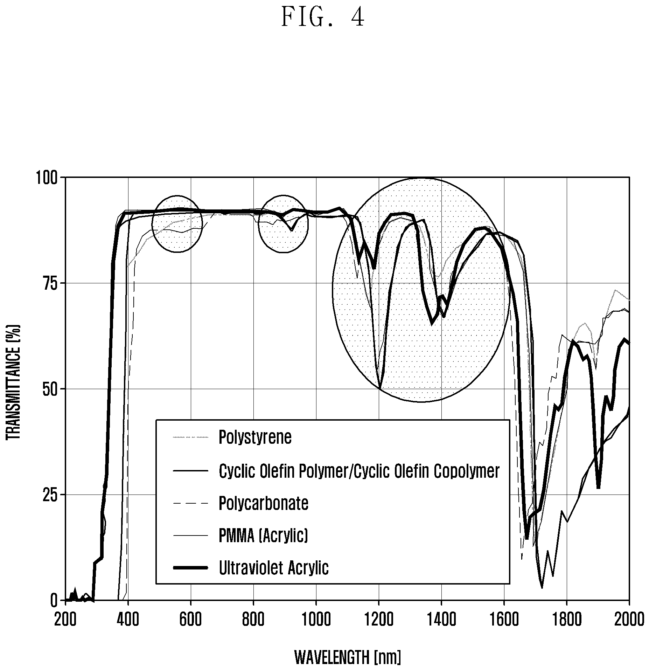

FIG. 4 is a graph showing the transmittance measured for various polymers including polymethyl methacrylate (PMMA).

Specifically, it can be seen that the transmittance of PMMA, which is known to have high transmittance, is also slightly reduced near a wavelength region of 850 nm. This suggests that there is a need for a more improved material with no change in transmittance even near that wavelength region.

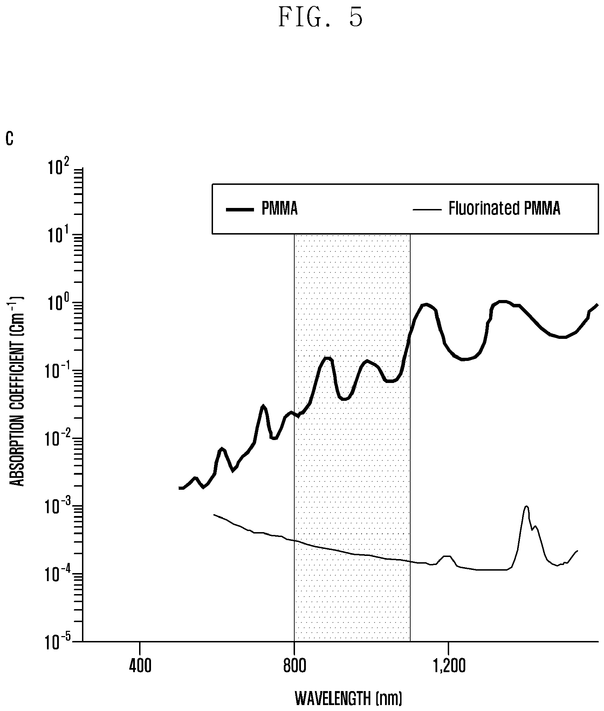

FIG. 5 is a graph showing the absorption coefficient [cm⁻¹] of resin/polymer made of polymethyl methacrylate (PMMA) and fluorinated PMMA.

Specifically, when the resin/polymer is made of PMMA, it can be seen that it has an absorption coefficient between about 10⁻³ and 10° over the entire wavelength region between 500 nm and 1500 nm, and it can be seen that as the wavelength increases, the absorption coefficient increases along with an inconsistent range of fluctuations. On the other hand, when the resin/polymer is made of fluorinated PMMA, it can be seen that it has a lower absorption coefficient than that of PMMA over the entire wavelength region between 500 nm and 1500 nm, and it can be seen that unlike the case of PMMA, the absorption coefficient decreases uniformly as the wavelength increases. In particular, it can be seen that in the vicinity of 850 nm, the absorption coefficient of fluorinated PMMA is about 10⁻⁴ (cm⁻¹), which is a low about 1000 times that of PMMA having an absorption coefficient of about 10⁻¹ (cm⁻¹).

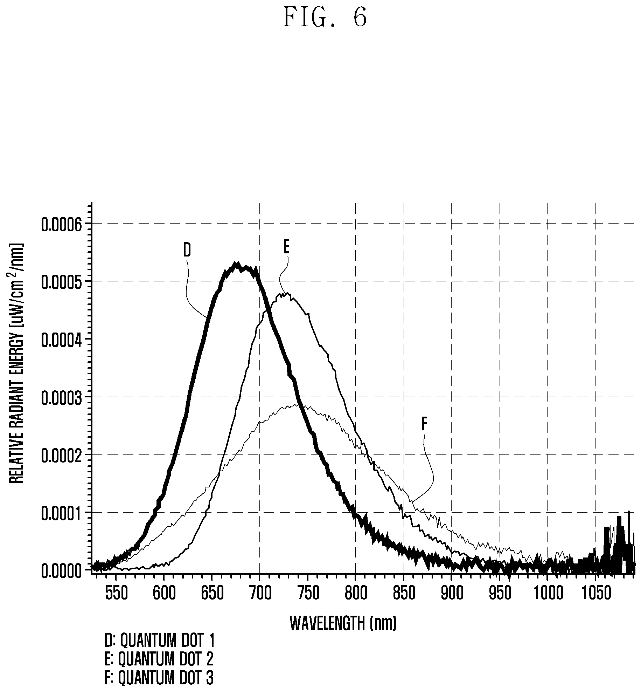

FIG. 6 is a graph showing the photoluminescence spectrum of quantum dots constituting a light concentrator according to the disclosure.

Specifically, it can be seen that quantum dot 1, quantum dot 2, and quantum dot 3 have a peak emission wavelength between 650 nm and 700 nm, between 700 nm and 750 nm, and 720 nm and 770 nm, respectively, and also have a full width at half maximum (FWHM) of about 150 nm, 170 nm, and 240 nm, respectively.

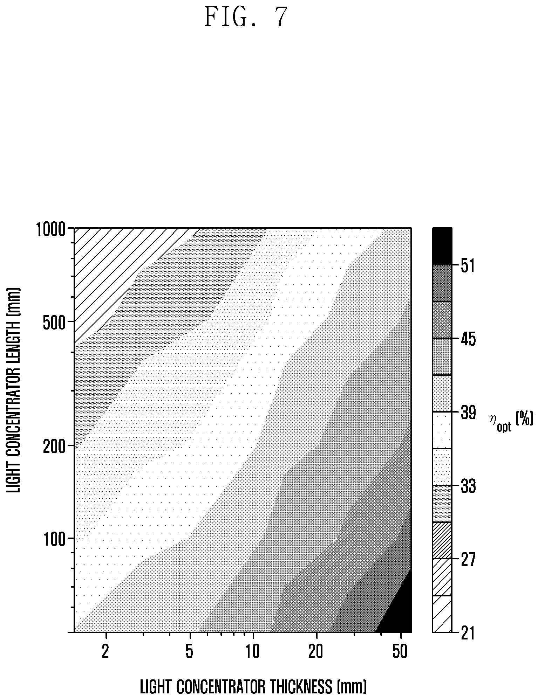

FIG. 7 is a diagram showing the efficiency of a light concentrator measured through a Monte-Carlo simulator using length (mm) and thickness (mm) as variables for the square-sized light concentrator based on quantum dot 1 according to the disclosure. In the disclosure, "the efficiency of a light concentrator" may refer to "the intensity of light emitted from the sides of the light concentrator with respect to the intensity of light incident on the light concentrator (light incident on the upper surface of the light concentrator)".

Specifically, it can be seen that the efficiency (ηₒₚₜ) of the light concentrator increases as the thickness of the light concentrator increases, whereas the efficiency decrease as the length increases. In other words, it can be seen that the efficiency of the light concentrator is inversely proportional to a cross-sectional aspect ratio (length/thickness) of the light concentrator.

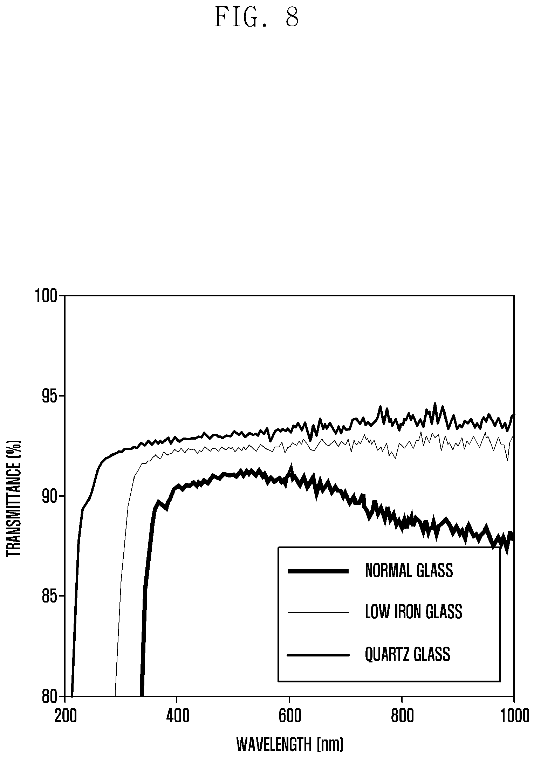

FIG. 8 is a graph showing the transmittance depending on normal glass, low iron glass, and quartz glass.

Specifically, over the entire wavelength region between 400 nm and 1000 nm, it can be seen that normal glass has a transmittance of approximately 87 to 92%, whereas low iron glass and quartz glass have a transmittance of approximately 92 to 95%.

More specifically, used in the disclosure are low iron glass and quartz glass. Normally used glass contains SiO₂ of 65 to 75%, CaO of 5 to 15%, Na₂CO₃ of 10 to 20%, etc. with respect to the total weight of the composition. Meanwhile, "low iron glass" may refer to "glass in which the ratio of the total weight of FeO, Fe₂O₃, and Fe₃O₄ to the total weight of the glass is 0.01% or less". Also, the quartz glass used in the disclosure is a glass made of pure silicon dioxide (SiO2) only.

### Embodiments

Hereinafter, embodiments of the disclosure will be described in detail. The following embodiments are, however, only exemplary to help the understanding of the disclosure, and the disclosure is not limited to the following embodiments.

### <Experimental Example 1> Experiment on transmittance of quantum dot dispersion resin/polymer

In order to specify the photoluminescence characteristics of the quantum dots used in the quantum dot light concentrator according to the disclosure, the transmittance of the resin/polymer constituting the quantum dot light concentrator was preliminarily evaluated through the following materials and sizes.

Prior to the experiment on transmittance, as described above, the resin/polymer was prepared with each of a material A of isobornylacrylate (IBOA), a material B in which the IBOA and dipentaerythritol hexaacrylate (DPHA) are mixed in a weight ratio of 3:1, and a material C in which photoinitiator Oxe-02 is added to the material B in a weight ratio of 3%. In this case, all the resins/polymers were prepared in the same size of 10 cm (length) × 10 cm (length) × 1 cm (thickness), and the experiment was carried out.

With reference to FIG. 3, all the resins/polymers made of the materials A, B, and C have a rapidly increased transmittance around a wavelength of about 400 nm, and then have an almost constant transmittance of about 90% from a wavelength of about 500 nm or more. However, it was observed that all the resins/polymers made of the materials A, B, and C have a slightly decreased transmittance in the vicinity of a wavelength region of approximately 850 nm. This was confirmed because all the materials A, B, and C of the resin/polymer are organic materials including C-H bonds, and the absorption wavelength of the C-H bonds is in the 850 nm region.

This means that the longest wavelength of quantum dots should be less than 850 nm. Also, this suggests that in order to provide the quantum dot-based light concentrator and the photovoltaic module including the same according to the disclosure, the quantum dot dispersion resin/polymer having excellent transmittance should be provided.

### <Comparative Example 1> Comparison of transmittance between PMMA and fluorinated PMMA

With reference to FIG. 4, when the resin/polymer is made of polymethyl methacrylate (PMMA), it can be seen that the transmittance is slightly reduced in the vicinity of a wavelength of 850 nm as in case of polystyrene or polycarbonate.

Based on the comparative example 1 and FIG. 4, the resin/polymer constituting the quantum dot light concentrator was prepared in the same size as in the experimental example 1, but was made of each of polymethyl methacrylate (PMMA) and fluorinated PMMA. Then, additional experiments were performed. The experimental results are shown in FIG. 5, and in this case, the lower the absorption coefficient [cm⁻¹], the higher the transmittance.

With reference to FIG. 5, it can be seen that the resin/polymer has a lower absorption coefficient over the entire wavelength region between 500 nm and 1500 nm when the resin/polymer is made of fluorinated PMMA than made of PMMA. In particular, it can be seen that in the vicinity of 850 nm, the absorption coefficient of fluorinated PMMA is about 10⁻⁴ (cm⁻¹), which is a low about 1000 times that of PMMA having an absorption coefficient of about 10⁻¹ (cm⁻¹).

Therefore, as the results of the above experiments, it is preferable that the "resin film layer 110" and the "polymer layers of the upper and lower layers 120 and 130" constituting the quantum dot-based light concentrator according to the first aspect and the "polymer layer 110A" according to the second aspect are made of fluorinated PMMA.

### <Experimental Example 2> Efficiency evaluation of Quantum dots and quantum dot-based light concentrator

Prior to evaluating the efficiency of the light concentrator according to the disclosure, the photoluminescence characteristics of the quantum dots constituting the light concentrator were preliminarily evaluated. FIG. 6 is a graph showing the photoluminescence characteristics of quantum dot 1, quantum dot 2, and quantum dot 3, and the photoluminescence characteristics are shown as specific values (unit: nm) of a peak wavelength and spectral full width at half maximum (spectral FWHM) in Table 1 below.

**[Table 1]**

| | Peak wavelength | Spectral FWHM |
|---|---|---|
| Quantum dot 1 | 670 | 150 |
| Quantum dot 2 | 720 | 170 |
| Quantum dot 3 | 735 | 240 |

### <Glossary>

- Peak wavelength: The wavelength at which light is emitted with the maximum intensity in the photoluminescence spectrum
- Spectral FWHM: The interval between two wavelengths having an intensity of 1/2 of the emission peak appearing in the photoluminescence spectrum

As can be seen in Table 1, the peak wavelength of quantum dot 1 appearing in the photoluminescence spectrum is 670 nm, which is smaller than those of quantum dots 2 and 3, and also the spectral FWHM of quantum dot 1 is 150 nm, which is smaller than those of quantum dots 2 and 3.

Based on the above efficiency evaluation of quantum dots, a light concentrator of 10 cm (length) × 10 cm (length) × 1 cm (thickness) was prepared and the light efficiency of the light concentrator based on the quantum dots 1, 2, and 3 was measured. The results are shown in Table 2 below.

**[Table 2]**

| | Light concentrator based on quantum dot 1 | Light concentrator based on quantum dot 2 | Light concentrator based on quantum dot 3 |
|---|---|---|---|
| Light efficiency | 41.1% | 26.6% | 21.3% |

With reference to Table 2, the light efficiencies of the light concentrators based on the quantum dots 2 and 3 were measured to be 26.6% and 21.3%, respectively, and the light efficiency of the light concentrator based on the quantum dot 1 was 41.1%, which is significantly higher than the light efficiencies of the light concentrators based on the quantum dots 2 and 3. In other words, it can be seen that the light efficiency of the light concentrator gradually decreases as the wavelength approaches 850 nm, and decreases significantly upon reaching 850 nm. This is confirmed, considering the photoluminescence characteristics of the quantum dots shown in Table 1, because the peak wavelength of the quantum dot 1 was measured at the farthest point from the 850 nm wavelength region corresponding to the absorption wavelength of the C-H bond among quantum dots, and the FWHM of the quantum dot 1 was the smallest.

Therefore, the experimental example 2 supports the experimental results of the experimental example 1 that the longest wavelength of the quantum dot is more advantageous as it is smaller than 850 nm. It is therefore desirable that the light concentrator according to the disclosure uses the quantum dot 1.

### <Experimental Example 3> Measurement of efficiency of light concentrator depending on various sizes

In the experimental example 2, a light concentrator based on the quantum dot 1, which was evaluated to have the best efficiency, was prepared in a square shape, and the light efficiency was measured by using the length and thickness as variables. The results are shown in Table 3 below (unit: %).

**[Table 3]**

| | | | | | | |
|---|---|---|---|---|---|---|
| Size | Length | Thickness | Length | Thickness | Length | Thickness |
| | 50 mm | 1.4 mm | 100 mm | 1.4 mm | 100 mm | 10 mm |
| Efficiency | 36.2% | | 32.1% | | 41.1% | |

With reference to Table 3, when the light concentrator has a length of 50 mm and a thickness of 1.4 mm, the light efficiency is 36.2%. In addition, when the light concentrator was 100 mm long and 1.4 mm thick, the light efficiency was measured to be 32.1%. Therefore, it was confirmed that the efficiency of the light concentrator decreases as the length increases. On the other hand, when the light concentrator has a length of 100 mm and a thickness of 100 mm, the light efficiency was measured to be 41.1%. Therefore, it was confirmed that the efficiency of the light concentrator increases as the thickness increases.

Therefore, it can be seen that the efficiency of the light concentrator is inversely proportional to the cross-sectional aspect ratio (length/thickness) of the light concentrator, which is also consistent with the Monte-Carlo simulator results with the size as a variable shown in FIG. 7. However, because the weight per unit area of the light concentrator increases excessively if the cross-sectional aspect ratio of the light concentrator becomes too small, the lower limit as well as the upper limit of the cross-sectional aspect ratio of the light concentrator are set as follows.

The cross-sectional aspect ratio (length/thickness) of the light concentrator is preferably 50 to 200, more preferably 70 to 140, and particularly preferably 80 to 120.

Therefore, the thickness required for each area of the light concentrator is preferably area(cm²)/40,000(cm) to area(cm²)/2,500(cm), more preferably area(cm²)/20,000(cm) to area(cm²)/5,000(cm), and particularly preferably area(cm²)/15,000(cm) to area(cm²)/8,000(cm) (e.g., when thickness is expressed as area/10,000, the thickness is 1 cm in an area of 1 m²).

### <Experimental Example 4> Measurement of light efficiency of light concentrator depending on various glasses

Light concentrators having a size of 100 mm in length and 10 mm in thickness were prepared by making contact with each of 'commercially available normal glass', 'low iron glass in which the ratio of the total weight of FeO, Fe₂O₃, and Fe₃O₄ to the total weight of the glass is 0.01% or less', and 'quartz glass containing 100% pure SiO₂' on the upper and lower surfaces of the resin/polymer layer in which quantum dots 1 are dispersed.

With respect to the light concentrators prepared as above, light having a wavelength range of 400 nm to 700 nm was incident to measure the light efficiency, and the results are shown in Table 4 below.

**Table 4**

| | Normal glass | Low iron glass | Quartz glass |
|---|---|---|---|
| efficiency | 22.9% | 41.1% | 42.3% |

As can be seen in Table 4, the efficiency of the light concentrator using normal glass was measured to be 22.9%, and the efficiencies of the light concentrators using low iron glass and quartz glass was 41.1% and 42.3%, respectively, which are higher than the case of using normal glass.

Therefore, it can be seen that the glass layer constituting the light concentrator according to the first aspect of the disclosure is preferably selected from low iron glass, quartz glass, or high-transmittance glass equivalent thereto, and furthermore, preferably formed of glass having an average transmittance of 91% to 95% at 400 nm to 1000 nm, more preferably having an average transmittance of 92% to 95% at 400 nm to 1000 nm, and particularly preferably having an average transmittance of 94% to 95% at 400 nm to 1000 nm.

In the disclosure, "average transmittance at 400 nm to 1000 nm" may refer to "a value obtained by dividing the integral value of transmittance over a wavelength region from 400 nm to 1000 nm by 600 nm (i.e., 1000 nm minus 400 nm)".

Meanwhile, embodiments of the disclosure and the accompanying drawings are only examples presented in order to easily describe the disclosure and facilitate comprehension of the disclosure, but are not intended to limit the scope of the disclosure. Therefore, the scope of the disclosure should be construed as including all changes or modifications derived from the technical contents of the disclosure in addition to the embodiments disclosed herein.

## Claims

1. A light concentrator based on a quantum dot, comprising:
a resin film layer in which quantum dots are dispersed;
an upper layer in contact with an upper surface of the resin film layer; and
a lower layer in contact with a lower surface of the resin film layer,
wherein each of the upper layer and the lower layer is selected from a glass layer or a polymer layer.

2. A light concentrator based on a quantum dot, comprising:
a polymer layer in which quantum dots are dispersed,
wherein the polymer layer is provided in a form of slab.

3. The light concentrator of claim 1 or claim 2, wherein a longest wavelength of the quantum dot is 650 nm to 900 nm.

4. The light concentrator of claim 1, wherein the glass layer has an average transmittance of 91% to 95% at 400 nm to 1000 nm.

5. The light concentrator of claim 1 or claim 2, wherein the polymer layer is selected from the group consisting of clear polyimide, fluorinated polymethyl methacrylate (fluorinated PMMA), and fluorinated polyimide.

6. The light concentrator of claim 1 or claim 2, wherein a cross-sectional aspect ratio (length/thickness) of the light concentrator is 50 to 200.

7. A photovoltaic module comprising:
a resin film layer in which quantum dots are dispersed;
an upper layer in contact with an upper surface of the resin film layer;
a lower layer in contact with a lower surface of the resin film layer;
an adhesive provided on sides of the resin film layer, the upper layer, and the lower layer; and
a photovoltaic cell attached to the adhesive,
wherein each of the upper layer and the lower layer is selected from a glass layer or a polymer layer.

8. A photovoltaic module comprising:
a polymer layer in which quantum dots are dispersed;
an adhesive provided on sides of the polymer layer; and
a photovoltaic cell attached to the adhesive,
wherein the polymer layer is provided in a form of slab.

9. The photovoltaic module of claim 7 or claim 8, wherein a longest wavelength of the quantum dot is 650 nm to 900 nm.

10. The photovoltaic module of claim 7, wherein the glass layer has an average transmittance of 91% to 95% at 400 nm to 1000 nm.

11. The photovoltaic module of claim 7 or claim 8, wherein the polymer layer is selected from the group consisting of clear polyimide, fluorinated polymethyl methacrylate (fluorinated PMMA), and fluorinated polyimide.

12. The photovoltaic module of claim 7 or claim 8, wherein the adhesive is selected from the group consisting of clear polyimide, fluorinated polymethyl methacrylate (fluorinated PMMA), and fluorinated polyimide.

13. The photovoltaic module of claim 7 or claim 8, wherein a cross-sectional aspect ratio (length/thickness) of the light concentrator is 50 to 200.
